# FASCICULE DE BREVET EUROPEEN

(11) **EP 1 190 379 B1**
(45) Date de publication et mention de la délivrance du brevet: **04.12.2002**
(21) Numéro de dépôt: 00927328.5
(22) Date de dépôt: 11.05.2000
(51) Int. Cl.: G06K 19/077

(54) **PROCEDE DE FABRICATION DE CARTES A PUCE A CONTACT AVEC DIELECTRIQUE BAS COUT**
VERFAHREN ZUR HERSTELLUNG EINER CHIP-KARTE MIT KONTAKTEN MIT KOSTENGÜNSTIGEM DIELEKTRIKUM
METHOD FOR PRODUCING CONTACT CHIP CARDS WITH A LOW-COST DIELECTRIC

(30) Priorité: 25.05.1999 FR 9906584
(43) Date de publication de la demande: 27.03.2002
(73) Titulaire: Gemplus, 13881 Gémenos Cedex (FR)
(72) Inventeur: DOSSETTO, Lucille, F-13600 La Ciotat (FR)
(74) Mandataire: Scheer, Luc
(86) Numéro de dépôt international: FR0001265
(87) Numéro de publication internationale: WO00072253

(56) Documents cités:
- EP-A- 0 246 744
- EP-A- 0 688 050
- EP-A- 0 774 779
- EP-A- 0 813 166
- WO-A-96/34361
- US-A- 4 879 153

## Description

L'invention concerne la fabrication de modules électroniques et de dispositifs électroniques portables où une puce est reliée à un bornier d'interface. Ces dispositifs sont par exemple des cartes à puce.

Ces cartes sont destinées à diverses opérations par exemple bancaires, téléphoniques, d'identification ou de télé billettique. Les cartes à contact comportent des métallisations affleurant la surface de la carte, disposées à un endroit défini par la norme ISO 7816.

Dans ce domaine, citons le document FR-A-2632100, qui est discuté dans la description, montre une carte à mémoire avec un module où est fixé sur la bande conductrice plane, un matériau isolant de renforcement, pour améliorer la résistance mécanique lors de la séparation du cadre conducteur du reste de la bande conductrice. Ce matériau est soit du KAPTON (page 6, ligne 23) soit un matériau photo polymérisable VACREL de Dupont.

Le document EP-A-0774779 décrit un micromodule à connecteur dont la grille comprend des barrières de protection qui délimitent une zone de moulage autour de la puce pour effectuer un moulage autour de la puce et dans cette zone.

Le document EP-A-0688050 décrit une carte sans module puisque le logement est muni de plages métalliques sur ses parois, la puce étant montée en flip chip sur ces plages par un adhésif anisotropique. Le logement (44) est rempli de résine.

La majorité des techniques de fabrication de carte à puce est basée sur l'assemblage d'un sous-ensemble appelé micromodule qui est encarté dans une cavité ménagée dans un corps de carte.

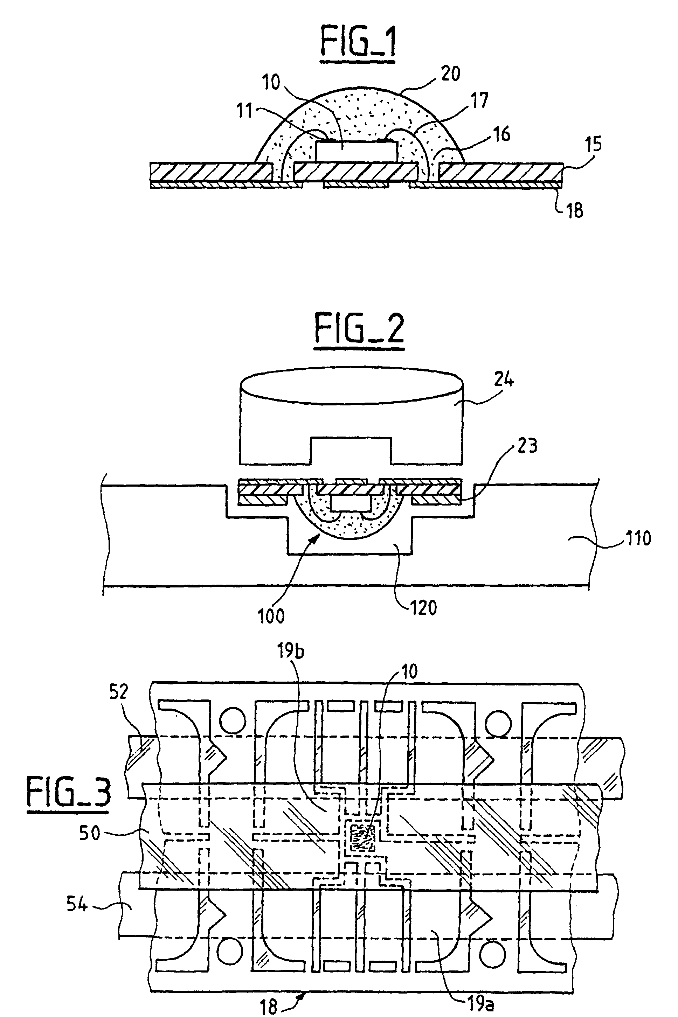

Une de ces techniques est illustrée sur la figure 1 et consiste à coller une puce 10 en disposant sa face active avec ses plots de contact 11 vers le haut, et en collant sa face opposée sur une feuille de support diélectrique 15. La feuille diélectrique 15 est disposée sur une grille de contact 18 telle qu'une plaque métallique en cuivre nickelé et doré. Des puits de connexion 16 sont pratiqués dans le support 15 afin de permettre que des fils de connexion 17 de relier les plots de contact 11 aux plages de connexion de la grille 18.

Selon certaines variantes, il est possible de coller la puce 10, face active vers le haut, directement sur la grille de contact 18, puis de la connecter par câblage filaire 17.

La grille 18 est déposée sur un support diélectrique 15 et les plages de contact sont définies par gravure chimique.

Une étape de protection ou d'encapsulation vient ensuite protéger la puce 10 et les fils de connexion 17 soudés. Généralement la technique appelée « glob top » consiste à verser une goutte de résine 20, à base d'époxy par exemple, thermodurcissable ou à réticulation aux ultraviolets, sur la puce 10 et ses fils de connexion 17.

Le support 15 avec la puce 10 est découpé en un micromodule 100 qui est encarté par dépôt d'une colle liquide dans la cavité avant report du micromodule.

La figure 2 illustre une autre technique d'encartage dans un corps 110.

Un film adhésif thermoactivable 23 est déposé par lamination à chaud sur le support 15 de préférence avant la découpe en un micromodule 100. Ce dernier est encarté dans une cavité 120 et collé en réactivant l'adhésif 23 par pressage à chaud au moyen d'une presse 24 dont la forme adaptée.

Ces techniques présentent des inconvénients. En particulier, elles sont coûteuses. Le diélectrique est généralement un composite de verre époxy ou en Kapton, haut de gamme. En effet, le diélectrique doit présenter une bonne tenue à la température afin d'être compatible avec l'encartage. De plus, la gravure chimique est une opération onéreuse.

Le document FR-A-2632100 est illustré sur la figure 3 et utilise un cadre conducteur (lead frame en anglais) sur lequel est directement fixée la puce de circuit intégré. Ce cadre conducteur est obtenu par découpage ou d'une bande métallique continue, ce qui permet de s'affranchir de l'opération de gravure chimique.

Des plages de contact 19a et des plages de connexion 19b ont été définies dans chaque cadre conducteur de la bande métallique 18.

Le procédé décrit dans ce brevet consiste essentiellement à laminer une première bande isolante 50 sur la face externe de la grille métallique 18 qui laisse les plages de contact 19a dégagées, et à laminer deux autres bandes isolantes 52 et 54 sur la face interne de la grille 18 qui encadrent les zones de connexions 19b de la puce 10. La puce est alors fixée sur la face interne de la grille par câblage filaire ou selon un procédé classique de puce retournée (« flip chip » en terminologie anglaise).

Cette technique oblige à laminer trois bandes de matériaux isolant sur la grille métallique, ce qui nécessite une grande précision dans l'indexation.

De plus, la bande isolante externe 50 est fixée provisoirement, elle est en effet destinée à être retirée avant l'utilisation de la carte.

En outre, la protection de la puce 10 et de ses fils de connexion 17 par enrobage dans une résine n'est pas facile due aux deux bandes d'isolant 52 et 54 situées sur la face interne de la grille 18 de part et d'autre de la puce 10.

Enfin, cette technique n'apporte pas une solution complète au problème du choix du diélectrique car ce dernier doit toujours présenter des propriétés thermiques compatibles avec les techniques classiques d'encartage.

Un but de l'invention est de pallier ces inconvénients.

A cet effet, l'invention est définie dans les revendications.

L'invention s'applique à tout dispositif à puce, tel qu'une carte, comprenant un module électronique.

L'invention permet d'obtenir, avec un procédé simple et économique, un micromodule de faible épaisseur, ayant une bonne tenue à l'humidité et avec un bornier de connexion ISO complètement plat.

En particulier, le procédé selon l'invention permet d'utiliser un diélectrique bas de gamme car ce dernier ne requière pas les propriétés classiques de compatibilité avec les techniques usuelles d'encartage.

En effet, et cela ressortira plus précisément dans la suite, le diélectrique ne couvre pas les plages de contact de la grille métallique. Or, lors de l'encartage, ce sont ces zones qui sont pressées ou collées avec une colle de type cyanoacrylate.

En outre, le procédé de fabrication selon l'invention présente l'avantage de permettre l'impression d'un logo ou d'un numéro de série ou de tout autre signe distinctif sur la bande diélectrique, à côté des plages de contact.

De plus, il est possible, dans le procédé selon l'invention de reporter la puce en utilisant l'adhésif enduit sur la bande diélectrique, et éviter ainsi une étape supplémentaire de collage.

D'autres particularités et avantages de l'invention apparaîtront à la lecture de la description donnée à titre d'exemple illustratif et non limitatif et faite en référence aux figures annexées qui représentent :
- la figure 1, déjà décrite, est un schéma en coupe transversale illustrant un procédé traditionnel de fabrication de carte à puce ;
- la figure 2, déjà décrite, illustre schématiquement l'encartage d'un micromodule selon un procédé connu ;
- la figure 3, déjà décrite, illustre un procédé de fabrication de carte à puce selon une technique de l'art antérieur ;
- la figure 4 est un schéma en coupe transversale d'un premier mode de réalisation du procédé de fabrication selon l'invention ;
- la figure 5 est un schéma en coupe transversale d'un deuxième mode de réalisation du procédé de fabrication selon l'invention ;
- la figure 6 est un schéma en coupe transversale d'un troisième mode de réalisation du procédé de fabrication selon l'invention ;
- la figure 7 illustre schématiquement l'encartage d'un micromodule selon le procédé de l'invention ;
- la figure 8 est une vue schématique de dessous, côté assemblage, du micromodule obtenu par le procédé selon l'invention ;
- la figure 9 est une vue schématique de dessus, côté contacts, du micromodule obtenu par le procédé selon l'invention.

Le procédé de fabrication selon l'invention comprend les étapes suivantes :

Un matériau isolant bas coût est fournit en bande et enduit d'un adhésif simple face. La bande de diélectrique 60 peut être obtenue par découpe d'un matériau diélectrique à une largeur prédéterminée.

Ce diélectrique 60 peut être constitué de PET (Polyéthylène Téréphtalate), de PEN (Polyéthylène Néréphtalate), de papier, de ABS (Acrylonitrile Butadiène. Styrène), de PVC (Polychlorure de Vinyle), ou de tout autre matériau isolant bas coût connu.

Parallèlement, une grille métallique 18 est réalisée à base d'une alliage de cuivre par exemple, et recouverte d'un dépôt électrolytique adapté au type de connexion que l'on souhaite réaliser, par exemple de l'Or ou du Nickel.

Des plages de contact 19a et de connexion 19b sont définies dans chaque cadre conducteur de la grille 18.

La grille 18 et le diélectrique 60 sont ensuite fixés solidairement, par lamination ou par tout autre moyen.

La bande diélectrique 60 est par exemple enduite d'un adhésif non pelable, c'est à dire inamovible, à température ambiante. Cet adhésif permet la fixation solidaire du diélectrique 60 et de la grille métallique 18.

Il peut s'agir, par exemple, d'un adhésif à réticulation sous étuve, activé suite à la lamination de la bande diélectrique 60 sur la grille 18.

Le film support diélectrique 60 est préférentiellement très fin de manière à satisfaire la norme ISO sur l'épaisseur finale du micromodule 100 obtenu par le procédé de l'invention.

Selon un mode de réalisation particulier de l'invention, la grille 18 est cambrée selon des méthodes classiques, par un poinçon par exemple.

La cambrure 80 de la grille métallique 18 est destinée à encaisser, au moins partiellement, la marche de l'épaisseur de la bande diélectrique 60 de manière à obtenir un micromodule 100 pratiquement plat du côté des contacts ISO.

Le diélectrique 60 sera à fleur des plages de contact 19a de la grille 18 tout en laissant ces dernière dégagée de manière à assurer la communication du circuit vers l'extérieur.

En outre, la cambrure 80 facilite la lamination du diélectrique 60 sur la grille 18 en constituant un guide pour la bande diélectrique.

La puce 10 est alors collée.

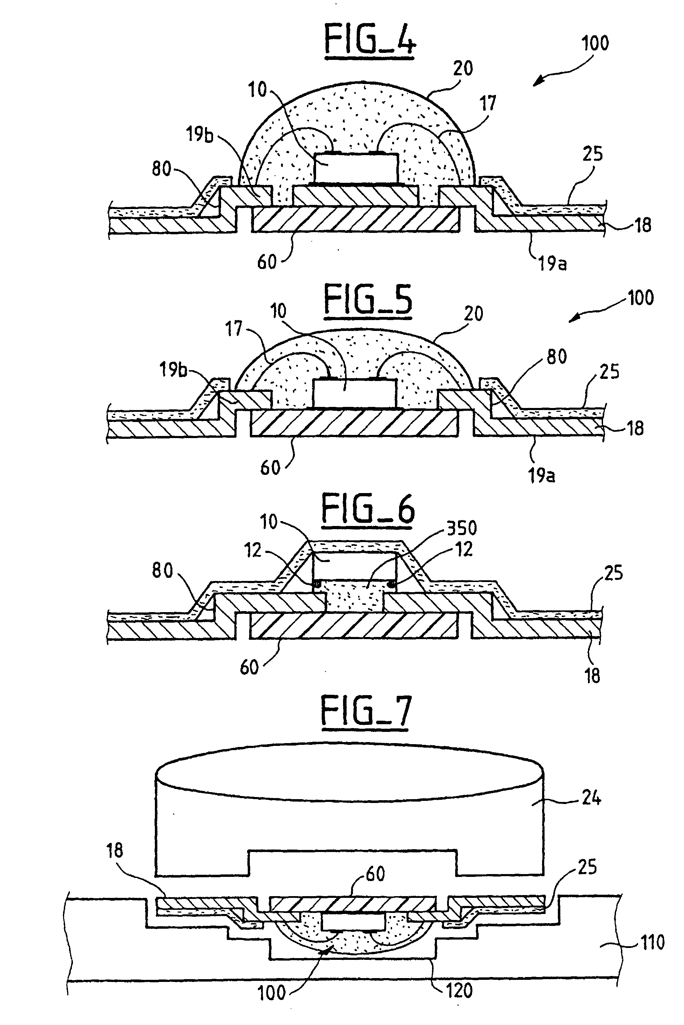

Sur la figure 4, la puce 10 est collée sur la grille 18 au pas du motif choisi, avec une colle conductrice ou non.

Sur la figure 5, la puce est collée directement sur le diélectrique 60. Ce collage peut se faire à chaud, l'adhésif de la bande diélectrique 60 étant alors thermoactivable, ou à froid sur un adhésif à température ambiante, appelé "tack." Selon les puces 10 utilisées, la colle choisie sera conductrice ou non. La puce 10 est alors connectée par câblage filaire, les fils de connexion 17 reliant les plots 11 de la puce 10 aux plages de connexion 19b de la grille 18.

La figure 6 illustre une réalisation dans laquelle la puce 10 est connectée aux plages de connexion 19b selon un procédé de type « flip chip » qui désigne une technique connue dans laquelle la puce est retournée.

Dans l'exemple illustré, la puce 10 est connectée à la grille métallique 18 au moyen d'une colle 350 à conduction électrique anisotrope bien connue et souvent utilisée pour le montage de composants passifs sur une surface. Les plots de sortie 11 de la puce 10 sont placés en vis à vis des plages de connexions 19b de la grille 18. Cette colle 350 contient en fait des particules conductrices élastiquement déformables qui permettent d'établir une conduction électrique suivant l'axe z (c'est à dire suivant l'épaisseur) lorsqu'elles sont pressées entre les plots de sortie 11 et les plages de connexion 19b, tout en assurant une isolation suivant les autres directions (x,y).

Dans une variante de réalisation, la connexion électrique entre la puce 10 et les plages de connexion 19b peut être améliorée par des bossages 12, en alliage thermofusible de type Sn / Pb ou en polymère conducteur, réalisés sur les plots 11 de la puce 10.

Après le report et la connexion de la puce 10 sur la grille métallique 18, le micromodule 100 doit être encarté dans la cavité d'un corps de carte.

Il est avantageux, comme cela a déjà été exposé en référence à l'art antérieur, de déposer, par lamination ou tout autre, moyen, un adhésif 25 ré activable à chaud ou à la pression sur toute la largeur utile de la grille 18. Dans la cas d'une connexion de la puce 10 à la grille 18 par câblage filaire, l'adhésif 25 aura été au préalable perforé afin de laisser libre la puce 10 et ses fils de connexion 17.

Éventuellement, une étape d'encapsulation vient protéger la face active de la puce 10 et ses fils de connexion 17 par dépôt d'une résine 20 qui enrobe la puce 10 et les fils 17.

Par exemple, l'adhésif 25 peut servir de barrière de limitation à l'étalement de la résine de protection 20.

Dans le cas d'une connexion de la puce 10 à la grille 18 par un procédé de « flip chip », comme décrit précédemment, l'adhésif 25 sera laminé sur toute la surface de la grille 18 et recouvrira la face arrière de la puce 10.

Le micromodule 100 est alors découpé à l'aide d'un poinçon matrice ou d'un faisceau laser, par exemple, puis reporté dans la cavité d'un corps de carte en réactivant l'adhésif 25 ou en déposant une goutte de colle de type cyanoacrylate par exemple dans la cavité.

La figure 7 illustre l'étape d'encartage du micromodule 100 dans la cavité 120 du corps de carte 110, par la technique du pressage à chaud pour réactiver l'adhésif 25.

Cette figure montre clairement que le pressage à chaud ne s'applique pas au diélectrique 60, mais uniquement à la grille métallique 18.

De même, si une technique de report avec une colle de type cyanoacrylate avait été choisie, la colle aurait été appliquée entre la cavité 120 du corps de carte 110 et la grille métallique 18, couverte ou non de l'adhésif ré activable 25, et non sur le diélectrique 60.

Ainsi, l'invention permet de s'affranchir d'un film support diélectrique placé sous la grille métallique, un tel film étant nécessairement onéreux à cause des caractéristiques qu'il doit présenter lors de l'encartage du micromodule.

L'invention compense la perte de rigidité mécanique par un film support diélectrique ordinaire disposé sur le dessus de la grille et s'étendant partiellement sur la grille.

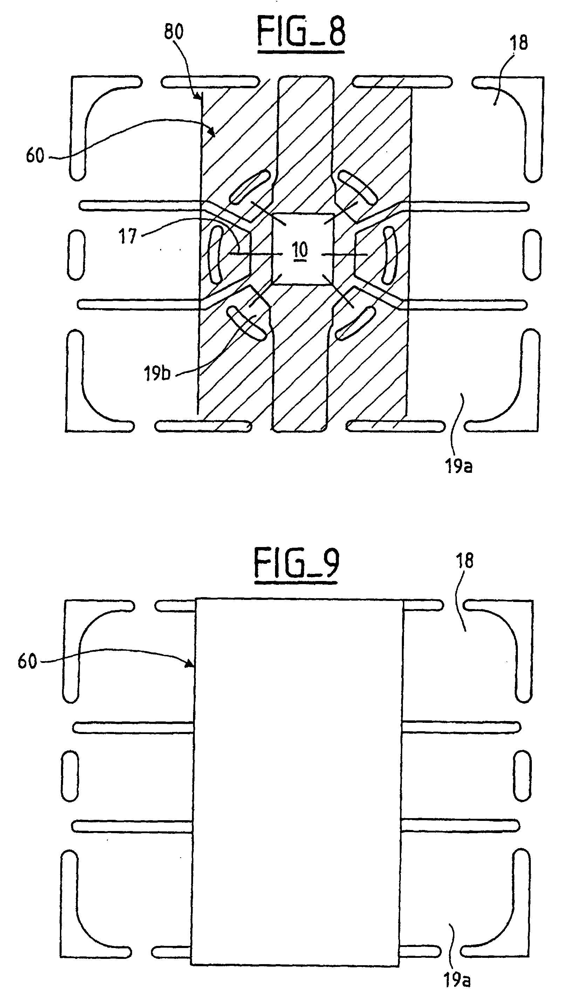

La figure 8 est une vue schématique de dessous, côté intérieur de la cavité du corps de carte, du micromodule obtenu par le procédé selon l'invention.

La cambrure 80 définit bien la limite entre les plages de contact 19a et les plages de connexion 19b, seules ces dernières étant couvertes par le diélectrique 60.

La figure 9 est une vue schématique de dessus, côté contacts ISO, du micromodule obtenu par le procédé selon l'invention.

Le diélectrique 60 est à fleur des plages de contact 19a de la grille métallique 18. L'extérieur de la carte à puce ainsi obtenue est donc parfaitement plat.

En outre, le bornier de connexion 18 de la carte à puce présente une zone médiane correspondant au diélectrique 60 sur laquelle un logo ou un dessin peut être imprimé (par exemple directement lors de la découpe du matériau isolant en bande).

Ce côté du diélectrique 60 pourra éventuellement être de couleurs différentes et/ou porter le numéro de série de la carte.

## Revendications

1. Procédé de fabrication d'un module électronique (100) à contact destiné à un dispositif électronique portable tel qu'une carte à puce ; ce procédé prévoyant de : obtenir une grille métallique (18) avec une face externe et une face interne, la grille métallique (18) étant pourvue de plages de contact (19a) ainsi que de plages de connexion (19b) à une puce (10) ; laminer un film support diélectrique (60) en bande sur la face externe de la grille métallique (18) en laissant les plages de contact (19a) dégagées ; coller la puce (10) et la connecter aux plages de connexion (19b) de la grille (18) ; découper le module (100) ; et déposer sur la face interne de la grille (18) un adhésif (25) ré activable ; **caractérisé en ce qu'**il comporte les étapes suivantes de :
- fourniture du film support diélectrique (60) qui est choisi à bas coût;
- réalisation d'une zone médiane de cambrure (80) dans la grille métallique (18) entre les plages de contact (19a) ; puis
- fixation inamovible du film support diélectrique (60) sur la face externe dans la cambrure (80), de manière à encaisser au moins partiellement la marche de l'épaisseur du film support diélectrique (60) et obtenir un module (100) pratiquement plat du côté de la face externe, ce qui compense la perte de rigidité mécanique.

2. Procédé selon la revendication 1, **caractérisé en ce que** le film support diélectrique (60) est obtenu par découpe d'un matériau en bande constitué de Polyéthylène Téréphtalate ou Polyéthylène Néré phtalate ou papier ou d'Acrylonitrile Butadiène Styrène ou Polychlorure de Vinyle, par exemple enduit d'un adhésif simple face.

3. Procédé selon la revendication 1 ou 2, **caractérisé en ce que** le film support diélectrique (60) bas coût est fixé à fleur des plages de contact (19a) et / ou est très fin, le module (100) fabriqué étant complètement plat et /ou de faible épaisseur.

4. Procédé selon l'une des revendications 1 à 3, **caractérisé en ce que** le film support diélectrique (60) comporte une face adhésive, non peiable c'est-à-dire inamovible à température ambiante, destinée à être fixée solidairement sur la grille métallique (18).

5. Procédé selon l'une des revendications 1 à 4, **caractérisé en ce que** le dépôt sur la face interne de la grille (18) d'un adhésif ré activable est effectué sur toute la largeur utile de cette grille (18), par exemple par laminage.

6. Procédé selon l'une des revendications 1 à 5, **caractérisé en ce que** préalablement au dépôt sur la grille (18) de l'adhésif ré activable (25) est perforé pour laisser passer la puce (10) et des connexions (17).

7. Procédé selon la revendication 6, **caractérisé en ce que** suite à la perforation de l'adhésif ré activable (25), cet adhésif (25) sert de barrière de limitation de l'étalement d'une résine (20) lors d'une étape d'encapsulation qui vient protéger la puce (10) et les connexions (17) par dépôt de cette résine (20).

8. Procédé selon l'une des revendications 1 à 5, **caractérisé en ce que** le dépôt sur la face Interne de l'adhésif ré activable (25) sur toute la largeur utile de la grille (18), est laminé sur toute la surface et recouvre la puce (10).

9. Procédé selon l'une des revendications 1 à 8, **caractérisé en ce qu'**après l'étape de dépôt d'adhésif (25) et éventuellement une étape d'encapsulation de la puce (10) par résine (20) ou recouvrement par un adhésif (25), le module (100) est découpé à l'aide d'un poinçon matrice ou d'un faisceau laser par exemple.

10. Module électronique (100) à contact destiné à un support à puce électronique tel qu'une carte à puce ; ce module (100) comportant : une grille métallique (18) avec une face externe et une face interne, la grille métallique (18) étant pourvue de plages de contact (19a) ainsi que de plages de connexion (19b) à une puce (10); un film support diélectrique (60) laminé sur la face externe de la grille métallique laissant les plages de contact (19a) dégagées ; la puce (10) et des connexions (17) aux plages de connexion (19b) ; et un dépôt sur la face interne de la grille (18) d'un adhésif (25) ré activable ; **caractérisé en ce que**
- le film support diélectrique (60) est un support de bas coût ;
- une zone médiane de cambrure (80) est réalisée dans la grille métallique (18) entre les plages de contact (19a) ; et
- le film (60) est fixé de manière inamovible sur la face externe dans la cambrure (80), de manière à encaisser au moins partiellement la marche de l'épaisseur du film support diélectrique (60), le module (100) étant pratiquement plat du côté de la face externe.

11. Module (100) selon la revendication 10, **caractérisé en ce que** le film support diélectrique (60) est obtenu d'un matériau constitué de Polyéthylène Téréphtalate ou Polyéthylène Néré phtalate ou papier ou d'Acrylonitrile Butadiène Styrène ou Polychlorure de Vinyle, par exemple enduit d'un adhésif simple face.

12. Module (100) selon la revendication 10 ou 11, **caractérisé en ce que** le film support diélectrique (60) bas coût est à fleur des plages de contact (19a) et / ou est très fin, le module (100) étant complètement plat et /ou de faible épaisseur.

13. Module (100) selon l'une des revendications 10 à 12, **caractérisé en ce que** le film support diélectrique (60) comporte une face adhésive, non pelable c'est-à-dire inamovible à température ambiante, fixée solidairement sur la grille métallique (18).

14. Module (100) selon l'une des revendications 10 à 13, **caractérisé en ce qu'**il est fabriqué selon le procédé de l'une des revendications 1 à 9 et que l'adhésif (25) ré activable est effectué sur toute la largeur utile de la grille (18), par exemple par laminage.

15. Module (100) selon l'une des revendications 10 à 14, **caractérisé en ce que** l'adhésif ré activable (25) est perforé et laisse passer la puce (10) et des connexions (17).

16. Module (100) selon la revendication 15, **caractérisé en ce que** la perforation de l'adhésif ré activable (25) sert de barrière de limitation de l'étalement d'une résine (20) d'encapsulation qui vient protéger la puce (10) et les connexions (17).

17. Module (100) selon l'une des revendications 10 à 14, **caractérisé en ce que** l'adhésif (25) sur la face interne est déposé sur toute la largeur utile de la grille (18) et recouvre la puce (10).

18. Module (100) selon la revendication 17, **caractérisé en ce qu'**il est fabriqué selon le procédé de l'une des revendications 1 à 9 et que la puce (10) est connectée à la grille métallique (18) par retournement, l'adhésif ré activable (25) étant laminé sur la grille métallique (18) et recouvre la face arrière de la puce (10).

19. Procédé de fabrication d'un dispositif électronique portable tel que carte à puce (10), **caractérisé en ce qu'**il comporte la fabrication d'un module (100) selon le procédé de l'une des revendications 1 à 9, ce module (100) étant reporté dans la cavité (120) du corps de carte (110) par activation de l'adhésif (25).

20. Procédé selon la revendication 19, **caractérisé en ce qu'**une impression est faite sur la zone médiane correspondant au film diélectrique (60) par exemple directement lors d'une étape de découpe du film support diélectrique (60) en bande, cette impression étant un logo ou dessin ou le numéro de série du dispositif électronique.

21. Dispositif électronique portable tel qu'une carte à puce (10), comprenant un module électronique (100) fabriqué selon le procédé de l'une des revendications 1 à 9 ou un dispositif électronique fabriqué selon le procédé de la revendication 19 ou 20, **caractérisé en ce qu'**il comporte un bornier pratiquement plat avec la grille de connexion (18), la zone médiane correspondant au film diélectrique (60) ayant une impression qui est un logo ou un dessin ou le numéro de série du dispositif électronique

## Patentansprüche

1. Herstellungsverfahren eines elektronischen Kontaktmoduls (100), das für eine tragbare elektronische Vorrichtung wie eine Chipkarte bestimmt ist; dieses Verfahren sieht vor:
Fertigung eines Metallgitters (18) mit einer Außen- und einer Innenseite; das Metallgitter (18) ist mit Kontaktstellen (19a) sowie mit Anschlußstellen (19b) zu einem Chip (10) ausgestattet; Walzen eines dielektrischen Trägerfilms (60) als Band auf der Außenseite des Metallgitters (18), wobei die Kontaktstellen (19a) frei bleiben; Kleben des Chips (10) und Anschluß des Chips an die Anschlußstellen (19b) des Gitters (18); Ausschneiden des Moduls (100) und Auftragen eines reaktivierbaren Klebstoffs (25) auf die Innenseite des Gitters (18);
und es zeichnet sich durch folgende Herstellungsschritte aus:
- Lieferung eines dielektrischen Trägerfilms (60), der kostengünstig ist;
- Ausführung einer Krümmungsmittelzone (80) in dem Metallgitter (18) zwischen den Kontaktstellen (19a), dann
- nicht abnehmbare Befestigung des dielektrischen Trägerfilms (60) an der Außenseite in der Krümmung (80), so daß zumindest teilweise die Dicke des dielektrischen Trägerfilms (60) eingebettet und ein Modul (100) erhalten wird, das auf der Außenseite praktisch flach ist, womit der Verlust der mechanischen Festigkeit ausgeglichen wird.

2. Verfahren nach dem ersten Anspruch, **dadurch gekennzeichnet, daß** der dielektrische Trägerfilm (60) durch Ausschneiden von Materialien in Bandform aus Polyethylenterephtalat oder Polyethylennerephtalat oder Papier oder Acrylnitril-Butadien-Styrol oder Polyvenylchlorid, beispielsweise mit einem einseitigen Klebemittel bestrichen, erhalten wird.

3. Verfahren nach Anspruch 1 oder 2, **dadurch gekennzeichnet, daß** der preisgünstige dielektrische Trägerfilm (60) auf gleicher Höhe wie die Kontaktstellen (19a) befestigt wird und/oder sehr dünn ist; daß das damit hergestellte Modul (100) ganz flach und / oder dünn ist.

4. Verfahren nach einem der Ansprüche 1 bis 3, **dadurch gekennzeichnet, daß** der dielektrische Trägerfilm (60) eine Haftseite hat, die sich bei Umgebungstemperatur nicht ablöst, das heißt nicht entfernbar ist, und zur wechselseitigen Befestigung auf das Metallgitter (18) vorgesehen ist.

5. Verfahren nach einem der Ansprüche 1 bis 4, **dadurch gekennzeichnet, daß** reaktivierbarer Klebstoff als Überzug auf der Innenseite des Gitters (18) über die ganze erforderliche Breite dieses Gitters (18), zum Beispiel durch Walzen, aufgetragen wird.

6. Verfahren nach einem der Ansprüche 1 bis 5, **dadurch gekennzeichnet, daß** vor Auftragen des Überzugs auf das Gitter (18) der reaktivierbare Klebstoff (25) zum Durchgang des Chips (10) und der Anschlüsse (17) perforiert wird.

7. Verfahren nach Anspruch 6, **dadurch gekennzeichnet, daß** im Anschluß an die Perforierungen im reaktivierbarem Klebstoff (25) dieses Klebemittel (25) die Ausbreitung des Harzes (20) während des Ummantelungsverfahrens, das mit der Harzablagerung (20) den Chip (10) und die Anschlüsse (17) schützt, eingrenzt.

8. Verfahren nach einem der Ansprüche 1 bis 5, **dadurch gekennzeichnet, daß** der Überzug auf der Innenseite aus reaktivierbarem Klebstoff (25) über die gesamte benötigte Breite des Gitters (18) gewalzt wird und den Chip (10) bedeckt.

9. Verfahren nach einem der Ansprüche 1 bis 8, **dadurch gekennzeichnet, daß** nach dem Anbringen des Klebemittelüberzugs (25) und gegebenfalls einer Ummantelung des Chips (10) mit Harz (20) oder eines Überzugs des Chips mit Klebstoff (25) das Modul (100) mit Hilfe eines Matrizenstempels oder beispielsweise eines Strahlenlasers ausgeschnitten wird.

10. Elektronisches Kontaktmodul (100) zur Unterstützung eines elektronischen Chips wie einer Chipkarte; das Modul (100) umfaßt ein Metallgitter (18) mit einer Außen- und einer Innenseite, das Metallgitter (18) ist mit Kontaktstellen (19a) sowie mit Anschlußstellen (19b) zu einem Chip (10) ausgestattet; einen dielektrischen Trägerfilm (60), der auf die Außenseite des Metallgitters (18) gewalzt wird, wobei die Kontaktstellen (19a) frei bleiben; den Chip (10) und die Anschlüsse (17) zu den Anschlußstellen (19b); und einen reaktivierbaren Klebstoff als Überzug (25) auf der Innenseite des Metallgitters (18), **dadurch gekennzeichnet, daß**
- der dielektrische Trägerfilm (60) eine kostengünstige Trägerlösung darstellt;
- eine Mittelzone in der Krümmung (80) des Metallgitters (18) zwischen den Kontaktstellen (19a) ausgeführt wird und
- der Film (60) nicht entfernbar an der Außenseite der Krümmung (80) befestigt wird, so daß zumindest teilweise die Dicke des dielektrischen Trägerfilms (60) eingebettet und ein Modul (100) erhalten wird, das auf der Außenseite praktisch flach ist.

11. Modul (100) nach Anspruch 10, **dadurch gekennzeichnet, daß** der dielektrische Trägerfilm (60) durch Ausschneiden von Materialien in Bandform aus Polyethylenterephtalat oder Polyethylennerephtalat oder Papier oder Acrylnitril-Butadien-Styrol oder Polyvenylchlorid, beispielsweise mit einem einseitigen Klebemittel bestrichen, erhalten wird.

12. Modul (100) nach Anspruch 10 oder 11, **dadurch gekennzeichnet, daß** der preisgünstige dielektrische Trägerfilm (60) auf gleicher Höhe wie die Kontaktstellen (19a) befestigt wird und/oder sehr dünn ist; daß das damit hergestellte Modul (100) ganz flach und / oder dünn ist.

13. Modul (100) nach einem der Ansprüche 10 bis 12, **dadurch gekennzeichnet, daß** der dielektrische Trägerfilm (60) eine Haftseite hat, die sich bei Umgebungstemperatur nicht ablöst, d.h. nicht entfernbar ist, und der wechselseitigen Befestigung auf dem Metallgitter (18) dient.

14. Modul (100) nach einem der Ansprüche 10 bis 13, **dadurch gekennzeichnet, daß** es nach dem Verfahren der Ansprüche 1-9 hergestellt wird und daß der reaktivierbare Klebstoff (25) über die gesamte erforderliche Breite des Gitters (18), zum Beispiel durch Walzen, aufgetragen wird.

15. Modul (100) nach einem der Ansprüche 10 bis 14, **dadurch gekennzeichnet, daß** der reaktivierbare Klebstoff (25) perforiert ist und den Chip (10) und die Anschlüsse (17) durchläßt.

16. Modul (100) nach Anspruch 15, **dadurch gekennzeichnet, daß** die Perforierung des reaktivierbaren Klebstoffs (25) als Begrenzung für die Ausweitung des Umkapselungsharzes (20) dient, der den Chip (10) und die Anschlüsse (17) schützt.

17. Modul (100) nach einem der Ansprüche 10 bis 14, **dadurch gekennzeichnet, daß** der Klebstoff (25) auf der Innenseite über die gesamte erforderliche Breite des Gitters (18) aufgetragen wird und den Chip (10) bedeckt.

18. Modul (100) nach Anspruch 17, **dadurch gekennzeichnet, daß** es nach dem Verfahren der Ansprüche 1-9 hergestellt wird und der Chip (10) umgedreht an das Metallgitter (18) angeschlossen wird ; der reaktivierbare Klebstoff (25) wurde auf das Metallgitter (18) gewalzt und bedeckt die Rückseite des Chips (10).

19. Herstellungsverfahren einer tragbaren elektronischen Vorrichtung wie einer Chipkarte (10), **dadurch gekennzeichnet, daß** es die Herstellung eines Moduls (100) nach dem Verfahren der Ansprüche 1-9 beinhaltet und dieses Modul (100) in die Krümmung (120) des Kartenkörpers (110) mittels Aktivierung des Klebstoffs (25) eingesetzt wird.

20. Verfahren nach Anspruch 19, **dadurch gekennzeichnet, daß** die dem dielektrischen Film (60) entsprechende Mittelzone bedruckt wird, zum Beispiel direkt während des Ausschneidens des dielektrischen Trägerfilms (60) in Bänder ; bei dem Druck kann es sich um ein Logo oder eine Zeichnung oder die Seriennummer der elektronischen Vorrichtung handeln.

21. Tragbare elektronische Vorrichtung wie zum Beispiel eine Chipkarte (10), die ein elektronisches Modul (100) beinhaltet, das nach dem Verfahren der Ansprüche 1-9 hergestellt wurde oder eine elektronische Vorrichtung, die nach einem Verfahren der Ansprüche 19-20 hergestellt wurde ; sie ist **dadurch gekennzeichnet, daß** sie eine praktisch flache Klemme mit einem Anschlußgitter (18) besitzt sowie eine dem dielektrischen Film (60) entsprechende Mittelzone, die mit einem Logo, einer Zeichnung oder der Seriennummer der elektronischen Vorrichtung bedruckt ist.

## Claims

1. A method of manufacturing an electronic module (10) of the contact type intended for a portable electronic device such as a smart card; this method making provision for: obtaining a metallic grille (18) with an external face and an internal face, the metallic grille (18) being provided with contact areas (19a) as well as areas (19b) for connection to a chip (10); laminating a dielectric support film (60) in strip film on the external face of the metallic grille (18) whilst leaving the contact areas (19a) clear; gluing the chip (10) and connecting to the connection areas (19b) of the grille (18); cutting the module (100); and placing a reactivatable adhesive (25) on the internal face of the grille (18); **characterised in that** it comprises the following steps of:
- supplying the dielectric support film (60) which is chosen so as to be of low cost;
- producing a middle curvature zone (80) in the metallic grille (18) between the contact areas (19a); and then
- fixing the dielectric support film (60) non-removably to the external face of the curvature (80), so as at least partially to absorb the movement of the thickness of the dielectric support film (60) and obtain a module (100) which is practically flat on the external face side, which compensates for the loss of mechanical rigidity.

2. A method according to Claim 1, **characterised in that** the dielectric support film (60) is obtained by cutting out a material in strip form consisting of polyethylene terephthalate or polyethylene nerephthalate or paper or acrylonitrile-butadiene-styrene or polyvinyl chloride, for example coated with a single-face adhesive.

3. A method according to Claim 1 or 2, **characterised in that** the low-cost dielectric support film (60) is fixed flush with the contact areas (19a) and/or is very thin, the fabricated module (100) being completely flat and/or of low thickness.

4. A method according to one of Claims 1 to 3, **characterised in that** the dielectric support film (60) has an adhesive face which is not peelable, that is to say which is non-removable at room temperature, intended to be securely fixed to the metallic grille (18).

5. A method according to one of Claims 1 to 4, **characterised in that** the deposition of a reactivatable adhesive on the internal face of the grille (18) is effected over the entire useful width of this grille (18), for example by lamination.

6. A method according to one of Claims 1 to 5, **characterised in that**, prior to deposition on the grille (18), the reactivatable adhesive (25) is perforated in order to allow the chip (10) and connections (17) to pass.

7. A method according to Claim 6, **characterised in that**, following the perforation of the reactivatable adhesive (25), this adhesive (25) serves as a barrier for limiting the spread of a resin (20) during an encapsulation step which protects the chip (10) and the connections (17) by the deposition of this resin (20).

8. A method according to one of Claims 1 to 5, **characterised in that** the deposition on the internal face of the reactivatable adhesive (25) over the entire useful width of the grille (18) is laminated over the entire surface and covers the chip (10).

9. A method according to one of Claims 1 to 8, **characterised in that**, after the step of deposition of adhesive (25) and possibly a step of encapsulation of the chip (10) by resin (20) or covering with an adhesive (25), the module (100) is cut by means of a die punch or a laser beam for example.

10. An electronic module (10) of the contact type intended for an electronic chip carrier such as a smart card; this module (100) having: a metallic grille (18) with an external face and an internal face, the metallic grille (18) being provided with contact areas (19a) as well as areas (19b) for connection to a chip (10), a dielectric support film (60) laminated on the external face of the metallic grille leaving the contact areas (19a) clear; the chip (10) and connections (17) to the connection areas (19b); and a deposit of a reactivatable adhesive (25) on the internal face of the grille (18); **characterised in that**
- the dielectric support film (60) is a low-cost support;
- a middle curvature zone (80) is produced in the metallic grille (18) between the contact areas (19a); and
- the film (60) is fixed non-removably to the external face in the curvature (80), so as to at least partially absorb the movement of the thickness of the dielectric support film (60), the module (100) being practically flat on the external face side.

11. A module (100) according to Claim 10, **characterised in that** the dielectric support film (60) is obtained from a material consisting of polyethylene terephthalate or polyethylene nerephthalate or paper or acrylonitrile-butadiene-styrene or polyvinyl chloride, for example coated with a single-face adhesive.

12. A module (100) according to Claim 10 or 11, **characterised in that** the low-cost dielectric support film (60) is fixed flush with the contact areas (19a) and/or is very thin, the fabricated module (100) being completely flat and/or of low thickness.

13. A module (100) according to one of Claims 10 to 12, **characterised in that** the dielectric support film (60) has an adhesive face which is not peelable, that is to say which is non-removable at room temperature, intended to be securely fixed to the metallic grille (18).

14. A module (100) according to one of Claims 10 to 13, **characterised in that** it is manufactured according to the method of one of Claims 1 to 9 and **in that** the reactivatable adhesive (25) is implemented over the entire useful width of the grille (18), for example by lamination.

15. A module (100) according to one of Claims 10 to 14, **characterised in that** the reactivatable adhesive (25) is perforated and allows the chip (10) and connections (17) to pass.

16. A module (100) according to Claim 15, **characterised in that** the perforation of the reactivatable adhesive (25) serves as a barrier for limiting the spread of an encapsulation resin (20) which protects the chip (10) and the connections (17).

17. A module (100) according to one of Claims 10 to 14, **characterised in that** the adhesive (25) on the internal face is deposited over the entire useful width of the grille (18) and covers the chip (10).

18. A module (100) according to Claim 17, **characterised in that** it is manufactured according to the method of one of Claims 1 to 9 and **in that** the chip (10) is connected to the metallic grille (18) by turning over, the reactivatable adhesive (25) being laminated on the metallic grille (18) and covers the rear face of the chip (10).

19. A method of manufacturing a portable electronic device such as a smart card (10), **characterised in that** it includes the manufacture of a module (100) according to the method of one of Claims 1 to 9, this module (100) being attached in the cavity (120) of the card body (110) by activation of the adhesive (25).

20. A method according to Claim 19, **characterised in that** an impression is made on the middle zone corresponding to the dielectric film (60) for example directly during a step of cutting the dielectric support film (60) in strip form, this impression being a logo or design or the serial number of the electronic device.

21. A portable electronic device such as a smart card (10), comprising an electronic module (100) manufactured according to the method of one of Claims 1 to 9 or an electronic device manufactured according to the method of Claim 19 or 20,
**characterised in that** it has a terminal block which is practically flat with the connection grille (18), the middle zone corresponding to the dielectric film (60) having an impression which is a logo or a design or the serial number of the electronic device.
